# DEMANDE DE BREVET EUROPEEN

(11) **EP 2 369 904 A1**
(43) Date de publication de la demande: **28.09.2011**
(21) Numéro de dépôt: 10305262.7
(22) Date de dépôt: 16.03.2010
(51) Int. Cl.: H05K 3/32, H05K 1/18, G06K 19/077, H05K 3/30

(54) **Module électronique à contacts latéraux, dispositif le comportant et procédé de fabrication d'un tel module**

(71) Demandeur: Gemalto SA, 92190 Meudon (FR)
(72) Inventeur: Ottobon, Stéphane, 83270 Saint Cyr sur Mer (FR); Dossetto, Lucile, 83270 Saint Cyr sur Mer (FR); Audouard, Laurent, 13400 Aubagne (FR)

(57) **Abrégé**

La présente invention concerne un module électronique comportant un corps isolant et un jeu de contacts électriques (9L) débouchant sur une face du corps, ladite face étant délimitée par des bords latéraux; Le module se distingue en ce qu'il comprend des languettes conductrices (19L) qui s'étendent au delà des bords latéraux (22, 23) du corps à partir desdits contacts électriques (9L).

Elle concerne également un dispositif comportant ledit module et un procédé de fabrication du module.

## Description

La présente invention concerne un module électronique comportant un corps isolant et un jeu de contacts électriques débouchant sur une face du corps, un procédé de fabrication de ce module et un dispositif ou équipement recevant ou adapté pour recevoir un tel module.

Plus particulièrement, le module est un module d'identification d'abonné (SIM) et le dispositif un équipement M2M.

En français, la terminologie « M2M » désigne de manière commune « communication de machine à machine ». La technologie M2M est notamment destinée à permettre aux machines, unités industrielles, véhicules, dispositifs ou plus généralement tout équipement, quel qu'il soit, de communiquer avec tout autre machine, unité industrielle, véhicule, dispositif, serveur ou plus généralement à tout équipement distant, et cela sans intervention humaine, par exemple pour des applications de télésurveillance, télémétrie, alerte, gestion de flottes de véhicules, assistance à la personne, etc.

Grâce a l'essor des technologies de communication sans fil (GSM, GPRS, EDGE, Wi-Fi...), le M2M s'impose aujourd'hui comme une solution extrêmement performante et compétitive par exemple pour la gestion de parcs de machines distantes : là où une intervention sur le terrain était incontournable pour surveiller, contrôler ou assurer la maintenance de machines reparties en divers endroits, la connectivite réseau intégré et les technologies web permettent une gestion centralisée à distance de ces mêmes machines.

Dans le cadre de l'utilisation de réseau(x) de télécommunications sans fil de type par exemple GSM, GPRS, le dispositif M2M utilisé comprend typiquement une unité de communication comprenant elle-même des moyens de traitement de signal en bande de base et en radiofréquence, et un module SIM qui peut prendre différents facteurs de forme.

Conventionnellement, dans un terminal de communication sans fil GSM par exemple, la carte SIM est un élément externe et amovible par rapport au terminal de communication auquel elle est associée. Elle a en effet pour objectif d'identifier un « abonné », qui peut être conduit à changer de terminal sans vouloir changer son identifiant associé à la carte SIM. La carte est disposée dans un logement prévu dans le dispositif de communication et est introduite dans ce logement par glissement dans une fente ou ouverture prévue à cet effet. Elle peut être changée physiquement durant la durée de vie du dispositif de communication, par exemple afin d'obtenir plus de fonctionnalités ou pour changer d'opérateur ou afin de pouvoir changer de manière aisée et à moindre cout un module défaillant sans devoir remplacer le dispositif complet de communication.

Pendant la production des cartes SIM, dans une phase appelée personnalisation, le fabricant, procède à la mise en place dans la carte SIM des fonctions demandées par l'opérateur ainsi qu'au stockage des paramètres de l'opérateur (par exemple des clés secrètes, des algorithmes de cryptage,...).

Dans le cadre d'applications M2M, les unités de communication sont souvent enfouis dans des équipements et donc difficilement accessibles. Ils peuvent être soumis à de rudes environnements (température, humidité contraintes physiques, etc....). De telles unités de communication sont associées à un module ou une carte SIM dans le domaine des communications M2M, l'ensemble unité de communication / module SIM devant être conditionné pour résister notamment aux contraintes environnementales, de sécurité, de fiabilité, et satisfaire aux contraintes d'accessibilité (un remplacement de la carte SIM pouvant être requis par exemple en réponse à la souscription à un nouvel abonnement) et de manipulation industrielle.

Pour remédier selon la technique antérieure aux problèmes de contraintes environnementales, de fiabilité et de manipulation industrielle, on peut ne pas recourir aux formats standards des cartes SIM, tels que définis par les recommandations GSM (plug ID-000 format or 2FF ou aussi 3FF selon la norme ETSI TS 102.221).

Dans ce cas alors, il est souvent prévu de souder un circuit intégré ou un composant le comprenant, directement sur l'unité de communication. On remédie ainsi aux problèmes de manipulation industrielle qui peuvent se poser car il n'est plus nécessaire d'insérer latéralement par glissement une carte SIM dans une fente ou une zone de réception prévue à cet effet dans l'unité de communication, cette opération étant difficile à industrialiser. Cependant cette solution utilisant la technique antérieure à circuit intégré soudé rend impossible ou difficile tout changement ultérieur post-soudage du circuit intégré intégrant la fonction SIM, par exemple lorsqu'un changement d'abonnement est souhaité.

D'autre part, on connait des modules M2M qui ne sont pas autorisés à être soudés (en raison de leur faible résistance à la température ou parce qu'ils sont prévus pour être facilement amovibles) et qui ont leurs contacts métalliques débouchant sur une face principale. Lorsqu'ils sont placés dans un connecteur par insertion verticale (dans une direction perpendiculaire à un support de connecteur notamment un PCB), l'épaisseur totale du connecteur additionné d'un couvercle de maintien ou de verrouillage d'un bon contact électrique, est trop important pour certaines applications matérielles. Une bonne connexion exige dans la plupart des cas un couvercle ou des loquets pour maintenir le module en appui sur des contacts élastiques du connecteur.

La présente invention vise à remédier aux inconvénients de la technique antérieure. Elle propose une structure de module qui remédie aux problèmes de contraintes environnementales, de fiabilité, d'accessibilité, mais également d'interchangeabilité et de manipulation industrielle connus dans la technique antérieure.

L'invention propose notamment de réduire considérablement l'épaisseur totale de l'ensemble connecteur et module en position fonctionnelle et opérationnelle de connexion.

Un autre objet est de concevoir un module permettant plusieurs types de montage que ce soit au travers de soudures ou avec des moyens d'insertion automatiques.

Un autre objet est de concevoir un module qui s'accommode également des connecteurs actuels épais avec couvercle ou loquets.

A cette fin, l'invention a pour objet un module électronique comportant un corps isolant et des contacts électriques débouchant sur une face du corps, ladite face étant délimitée par des bords latéraux; Le module se distingue en ce qu'il comprend des languettes conductrices qui s'étendent au delà des bords latéraux du corps à partir desdits contacts électriques.

Selon d'autres caractéristiques:
- Les languettes sont destinées chacune à être repliées sensiblement à angle droit vers une face de bord latéral du corps notamment pendant ou avant l'insertion dans un connecteur adapté au module;
- Les languettes sont espacées l'une de l'autre d'une distance supérieure à celle séparant les contacts auxquels elles sont attachées;
- Le module peut être un module SIM avec un facteur de forme compatible avec les équipements mobiles conventionnels à savoir le 3FF ou le 2FF.

L'invention a également pour objet un dispositif électronique comportant un connecteur recevant ou destiné à recevoir le module ci-dessus; Le dispositif peut être un simple connecteur, un équipement ou unité de communication comprenant un connecteur adapté selon l'invention, le connecteur comprenant ou non le module.

Selon une caractéristique, le connecteur comporte :
- un cadre isolant avec deux faces principales et des parois latérales internes définissant entre-elles une position fonctionnelle du module dans le connecteur,
- un accès à ladite position fonctionnelle, disposé sur une face principale du cadre et orienté de préférence vers l'extérieur du cadre;
- des contacts latéraux disposés au niveau des parois latérales internes du cadre, lesdits contacts latéraux étant destinés à connecter les languettes dudit module lorsqu'elles sont en position repliées.

L'invention a pour objet également un procédé de fabrication d'un module électronique comportant un corps isolant et des contacts électriques débouchant sur une face du corps, ladite face étant délimitée par des bords latéraux; Le procédé se distingue en ce qu'il comprend une étape de réalisation de languettes conductrices qui s'étendent au-delà des bords latéraux du corps, à partir desdits contacts électriques.

Selon d'autres caractéristiques, le procédé comprend les étapes suivantes de formation de contacts et languettes électriques par gravure ou par découpe d'une grille métallique, lamination d'un ruban isolant puis de surmoulage ou encartage dans un corps de carte d'au moins une puce électronique connectée aux contacts et disposé d'un côté des contacts; de découpe du module, les languettes s'étendant vers l'extérieur au delà d'une face principale du corps du module.

D'autres caractéristiques et avantages de la présente invention apparaîtront plus clairement à la lecture de la description qui suit en relation avec les dessins annexés correspondants dans lesquels:
- La figure 1 est une vue en coupe d'un connecteur selon l'art antérieur;
- La figure 2A est une vue en perspective d'un module selon une réalisation de l'invention;
- La figure 2B est une vue de côté du module montrant la face 22 du corps illustré à la figure précédente ;
- La figure 3 illustre un dispositif adapté à recevoir et connecter le module ;
- La figure 4 illustre une coupe selon A-A du dispositif de la figure 3 avec le module de l'invention de la figure 2A en position fonctionnelle dans un connecteur compris dans le dispositif ;
- La figure 5 illustre un élément de connexion avec moyen de verrouillage du module en position fonctionnelle dans un connecteur et un débattement de l'élément ;
- La figure 6 illustre des étapes de fabrication du module conforme à l'invention selon un procédé préféré de fabrication du module;

### DESCRIPTION DETAILLEE DE L'INVENTION

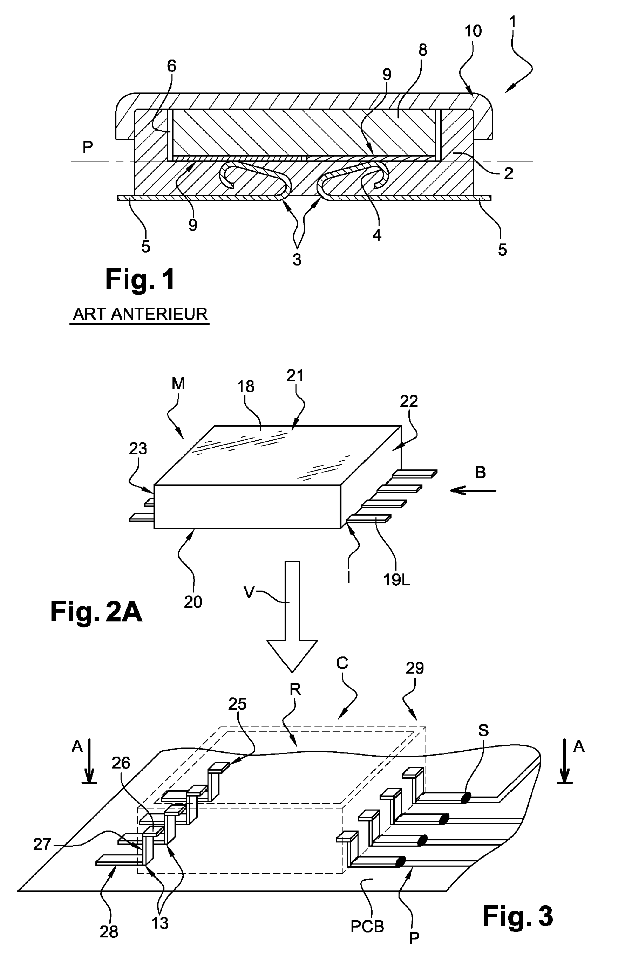

En référence à la figure 1, un connecteur 1 selon l'art antérieur comprend un support 2 en matériau isolant ayant une forme générale parallélépipédique comprenant une embase destinée à reposer par exemple sur un circuit imprimé (PCB) et une cavité 6 au dessus de l'embase débouchant en surface du support sur une face du parallélépipède opposée à l'embase. Cette embase reçoit N éléments conducteurs 3, N étant typiquement égal à 8. Ces N éléments conducteurs définissent, à des premières extrémités débouchant dans la cavité, N zones de contacts 4 respectives saillant superficiellement dans un plan (P) de réception du module dans la cavité du connecteur.

Des secondes extrémités 5 des éléments conducteurs 3 forment des bornes extérieures de couplage du connecteur, destinées typiquement à connecter, notamment par soudure, des bornes correspondantes d'un circuit imprimé (PCB) d'une unité de communication, par exemple GSM. Chaque zone de contact 4 du connecteur (destinée à entrer en contact 9 avec un contact correspondant du module) est formée par une portion superficielle tangentielle extérieure d'une lame élastiquement déformable incurvée, cette lame déformable étant rendue solidaire de l'embase du connecteur lors du moulage de ce dernier.

Le module électronique, par exemple un module M2M ou carte SIM se présente sous la forme conventionnelle au format 3FF d'un élément ou corps parallélépipédique 8 sur lequel sont formés des contacts ou plages de contact électriques 9 débouchant en surface du module. Le module est introduit dans la cavité 6 et se trouve en position fonctionnelle en contact avec les éléments conducteurs 4 par l'intermédiaire de ses plages de contacts 9.

Le connecteur comporte également un couvercle 10 couvrant l'entrée de la cavité et appuyant sur la face arrière du module (opposée aux plages de contact 9) à l'encontre d'une force élastique des éléments conducteurs 3 de manière à assurer une bonne connexion électrique des plages de contact avec lesdits éléments. L'épaisseur globale du connecteur avec le module en position fonctionnelle résulte du cumul de l'embase du corps 2, de l'épaisseur du module et du couvercle 9 soit environ 3 mm

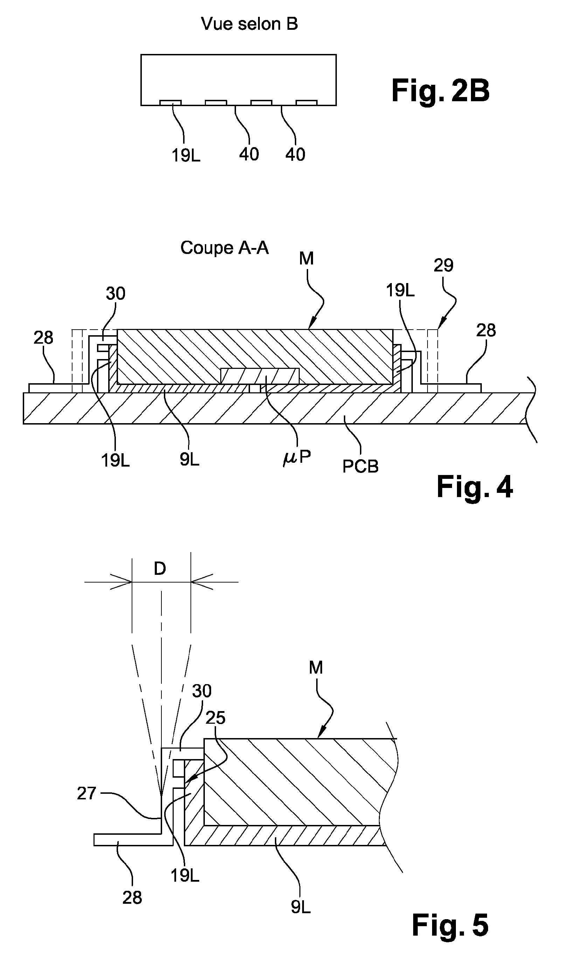

Comme illustré à la figure 2, un module électronique (M) conforme à un mode de réalisation, comporte un corps isolant 18 de forme générale parallélépipédique présentant une face principale avant 20 et une face arrière 21 opposée à la face principale. Il présente au moins un bord latéral (ou face latérale) 22 délimité par les deux faces principales opposées 20, 21 au moins sur un côté du corps mais de préférence sur deux côtés opposés 22,23.

Comme ordre de grandeur des surfaces des différentes faces et du bord latéral, on a dans l'exemple une épaisseur du corps entre les deux faces principales d'environ 0,4 à 2 mm tandis que les faces principales présentent, par exemple, une longueur et une largeur comprise entre 3 et 15 mm chacune.

Selon une caractéristique de l'invention, le module comprend des languettes conductrices 19L qui s'étendent au delà de la face principale 20 du corps (ou du bord latéral ou face latérale 22 du corps) à partir d'une interface (I) de chaque contact électrique 19 débouchant en surface du corps. L'interface (I) est notamment une section de la languette venant affleurer à la surface générale externe du corps (ou étant à la frontière entre une face latérale et l'extérieur) à partir de laquelle la languette s'étend pour se situer au delà de la surface principale du corps vers l'extérieur du corps.

Dans l'exemple, les bords latéraux concernés par des languettes sont au moins au nombre de 2 et correspondent à des bords latéraux externe 22, 23 opposés l'un de l'autre. Dans l'exemple, les languettes débouchent au niveau de chaque bord 22, 23 sensiblement à proximité d'une face principale 20. Les languettes s'étendent sensiblement perpendiculairement à la face de chaque bord 22, 23. Cette extension perpendiculaire résulte d'une étape du procédé mis en oeuvre et décrit ultérieurement. Le cas échéant, le module peut être délivré d'usine avec les languettes rabattues, vers ou sensiblement contre la face de son bord latéral adjacent.

Selon un mode de réalisation ou d'utilisation préféré du module, les languettes peuvent être destinées chacune à être repliées sensiblement à angle droit en direction d'une face de bord latéral à différentes étapes de fabrication ou de montage notamment pendant ou avant l'insertion dans un connecteur associé.

Les languettes ont de préférence une longueur dépassant du corps qui est inférieure à l'épaisseur du corps 18. Ainsi, une fois rabattues, l'extrémité des languettes ne dépasse pas l'épaisseur du corps isolant. Le cas échéant, l'invention peut prévoir de faire dépasser les languettes de manière qu'elles puissent être recourbées jusque sur une face principale. Ainsi, les languettes peuvent former des contacts à la fois sur des faces latérales, une ou deux faces principales opposées.

Selon un mode de réalisation préféré, les languettes s'étendent à partir de contacts électriques (19) débouchant ou affleurant sur au moins une face principale du corps, ladite face principale étant délimitée par des bords latéraux. Dans l'exemple, la face principale 20 comporte de préférence des plages de contacts notamment du type carte à puce selon la norme ISO 7816 ainsi que MFF1 de la norme ETSI et autres normes type JEDEC ou nouveaux standards à venir...

Comme illustré à la figure 3, l'invention prévoit un dispositif configuré ou adapté à recevoir et connecter le module M; Le dispositif peut comprendre simplement un jeu d'éléments de connexion ou consister en un simple connecteur destiné à coopérer avec le module M, un dispositif ou équipement notamment machine quelconque comportant des moyens configurés ou adaptés pour connecter le module ou connectant le module quand il est en position fonctionnelle.

Dans l'exemple, le dispositif est un circuit imprimé PCB portant des éléments de connexion électriques 13 pour connecter le module. Les éléments de connexion peuvent être de simples soudures S connectant directement les languettes 19L selon un mode de montage soudé à des pistes électriques P ou des éléments de connexion électriques 13 fixés sur un support tel que le PCB reliés à des pistes électriques S.

Des moyens de connexion du dispositif comportent un jeu de 8 éléments de connexion électrique disposés en deux rangés de 4 éléments se faisant face l'une à l'autre. Ces éléments sont configurés de manière à présenter chacun au moins un point de contact électrique 25 destiné à contacter une languette 19L correspondante du module; La languette est de préférence repliée sur une face latérale du module 22 ou 23.

Les éléments de connexion 13 sont agencés entre eux et sur un PCB de manière à définir un espace de réception du module entre les deux rangées visées ci-dessus et à exercer une force de contact électrique vers les bords ou faces latérales du module lorsqu'il est dans l'espace de réception, dans une direction parallèle au plan du PCB. Chaque élément dans l'exemple, comporte un tronçon de contact 26 sensiblement parallèle au PCB pour assurer un contact électrique au module; Il a de préférence une liberté de mouvement élastique parallèlement au plan du PCB ou perpendiculairement aux bords latéraux du module, un tronçon intermédiaire ou portion de lame 27 perpendiculaire au plan du PCB, portant le tronçon de contact 26 et pouvant se rapprocher élastiquement vers l'espace de réception ou s'en éloigner, un tronçon de base 28 parallèle au plan du PCB et fixé au PCB; Ce tronçon de base porte le tronçon intermédiaire et est destiné à être au contact des pistes conductrices P du PCB. Ces tronçons de base éléments peuvent être fixés directement au PCB, notamment par liaison soudée aux pistes P. Les rangées d'éléments peuvent être assemblées ensemble par l'intermédiaire d'un ou deux blocs de matière isolante comme le cadre 29.

A la figure 3, selon un mode de réalisation, le bloc isolant peut comprendre un cadre parallélépipédique 29 (en pointillé et non obligatoire), comportant au centre un espace de réception (R). Cet espace présente des dimensions correspondant sensiblement à l'encombrement du module et le cadre comprend une ouverture vers l'extérieur d'un côté situé à l'opposé du PCB (flêche V) permettant l'insertion du module de l'extérieur perpendiculairement au PCB. Ce cadre est par exemple réalisé en plastique moulé par surmoulage des éléments de connexion 13 au niveau des tronçons de base de manière à laisser un degré de liberté élastique aux tronçons intermédiaires. Le cas échéant, le tronçon de base peut comporter un moyen d'ancrage supplémentaire (non représenté) dans le bloc isolant.

Selon un mode de réalisation, les tronçons intermédiaires possèdent un débattement élastique (D) visible à la figure 5 s'étendant soit à l'intérieur, soit à l'extérieur du cadre, soit dans l'épaisseur des parois du cadre 29, en particulier dans des ouvertures adaptées ménagées dans les parois du cadre.

Comme illustré à la figure 4, le module M est disposé dans le dispositif ou connecteur de la figure 3 et chaque élément 13 de chaque rangée connecte une languette correspondante du module repliée contre un bord latéral du corps de module. Le cas échéant, le cadre peut comporter un fond très fin contre le PCB pour permettre notamment un montage au préalable du module dans le cadre avant de reporter l'ensemble sur le PCB ou une zone d'accueil d'un équipement.

Contrairement au support 2 de la figure 1, le cadre peut ne pas comporter de base ou de fond avec une épaisseur adaptée pour recevoir des lames ressorts 3. Le cadre ou support simplifié 29 selon l'invention, ne comporte pas non plus nécessairement de couvercle ayant la fonction de maintenir une force d'appui sur le module.

On observe par conséquent que le connecteur selon la construction de l'invention, est au choix en mesure d'être exempt d'embase recevant des ressorts et/ou de couvercle et de présenter de ce fait une épaisseur (entre les deux faces principales) beaucoup plus réduite par rapport à celui de la figure 1.

D'autre part, le module peut avantageusement offrir plusieurs types de connexion lorsque le module présente également des plages de contact débouchant sur une surface principale 20, les languettes étant un prolongement de ces plages de contact au delà du périmètre de la face principale 20. En effet, si le connecteur est comme celui de la figure 1, les languettes 19L peuvent être rabattues contre les bords du module et placées entre les parois verticales du support 2 et les faces latérales du module, la connexion du module avec les lames 3 s'effectuant comme décrit à la figure 1. Le cas échéant, chaque languette peut être repliée sur la face principale contre la plage de contact à laquelle elle est rattachée ou coincée entre le cadre et les faces 22 et 23. Ce qui peut permettre une insertion en force et donc un maintien renforcé dans le connecteur.

L'épaisseur des languettes est par exemple comprise entre 18 et 150 µm

Selon une autre utilisation, le module est disposé directement contre le PCB sans cadre support, les languettes étant déployées à plat contre le PCB ou une piste de connexion P parallèlement à la face principale et en dehors du périmètre du corps isolant. Dans ce cas, toute connexion de type connue peut être envisagée telle que connexion à colle conductrice, soudure, thermo compression, etc. L'invention permet donc au moins deux, voire trois modes de connexion différents possibles avec un même facteur de forme à languettes délivré d'usine (soudure des languettes notamment en étant déployées, connexion latérales, connexion classique via contacts sur face principale)

Comme montré aux figures 2A et 3, selon l'invention, le montage comprend les étapes suivantes. Tout d'abord, on aligne le module et le connecteur. On procède ensuite au déplacement vertical, selon un axe perpendiculaire au PCB (Flèche V), du module M vers le connecteur ou inversement. Dans cette phase, les languettes 19L connecteur vont se replier contre les bords du module notamment en heurtant les bords supérieur du cadre 29 et/ou en heurtant les éléments de contact 26 qui vont avoir tendance à s'écarter vers l'extérieur du cadre sous l'effet de l'insertion. Le cas échéant, les éléments de connexion viennent en butée contre les parois internes du cadre 29 et forcent ainsi les languettes à se replier plus.

Selon une variante de réalisation, il est prévu d'avoir des moyens de blocage du module en position fonctionnelle dans le cadre; Par exemple, l'invention prévoit au moins un élément de connexion comportant une encoche destinée à offrir une zone d'encliquetage d'un plot correspondant; Selon une variante, au moins un élément de connexion 13 peut comprendre une portion ou épaulement 30 pouvant s'écarter lors de l'insertion du module, puis s'étendre en partie au dessus de l'extrémité d'une languette lorsque le module est en position fonctionnelle dans le cadre de manière à former un obstacle au retrait du module. Selon une autre variante, le cadre comporte un ergot ou protubérance s'étendant à l'intérieur dans l'espace de réception du cadre et le module comporte une encoche correspondante pour empêcher le retrait du module.

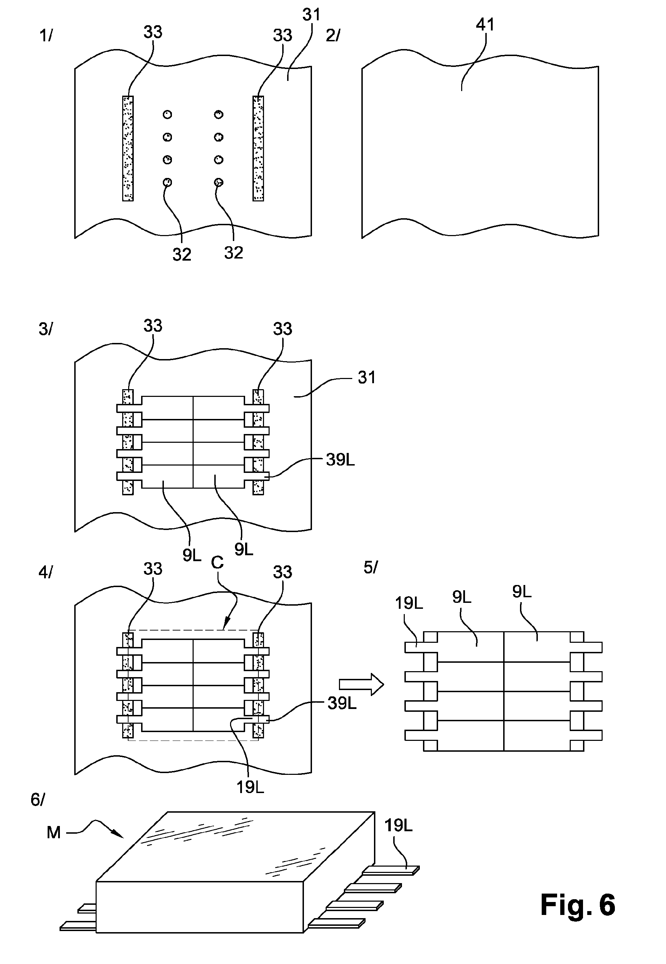

Comme illustré à la figure 6, un procédé préféré de fabrication du module, va maintenant être décrit en relation avec différentes étapes 1-6. Le procédé utilise de préférence une technologie de fabrication de module conformément à la technologie carte à puce mais n'est pas pour autant limité à cela. Cela permet notamment d'utiliser un parc machine actuel.

Selon un mode de mise en oeuvre, le procédé de fabrication d'un module électronique comprend l'étape de réalisation de languettes conductrices 19L s'étendant au delà des bords latéraux (ou face principale) du corps à partir de contacts électriques disposés ou débouchant sur la face principale.

A l'étape 1, un mode de réalisation prévoit de réaliser des perforations 32 sur un substrat isolant fourni de préférence sous forme d'une bande continue 31. Les perforations correspondant notamment à des trous d'accès à des plages de contact pour la connexion d'un composant électronique ou puce de circuit intégré. Le substrat comporte également des évidements rectilignes 33 (par exemple environ 1 à 2 mm de large de part et d'autre et au niveau des perforations 32.

A l'étape 2, le procédé prévoit de laminer un ruban de conducteur 41 (cuivre notamment) contre le substrat isolant pour former des "grilles conductrices contrecollés" (Lead-frame). A l'étape 3, le procédé prévoit une gravure du ruban conducteur permettant de réaliser des languettes 39L en prolongement de huit plages de contacts 9L, par exemple au format ISO 7816; Les languettes 39L s'étendent par dessus des évidements rectilignes adjacents 33 comme des ponts conducteurs, en joignant chaque bord longitudinal d'un évidement 33.

Aux étapes 4, 5, le procédé prévoit une découpe / extraction d'un module hors des rubans 31, 41; De préférence, au préalable ou après la découpe, le procédé prévoit le report, connexion, enrobage éventuel d'au moins un composant électronique au verso des plages de contact du côté du substrat isolant selon la technologie carte à puce. Au cours de la découpe, les languettes 39 sont découpées à l'intérieur de l'évidement selon le pointillé C sur la figure de manière à avoir des portions de languette 19L s'étendre de préférence au delà du substrat isolant extrait ou de la surface principale du module. Ces languettes 19L s'étendent "en l'air" et seront naturellement repliées lors de l'insertion dans un connecteur adapté ou non.

A l'étape 6, le procédé prévoit un enrobage du composant ou la formation d'un corps isolant du module notamment par surmoulage ou par encartage dans un corps de carte de manière classique.

A la figure 2B, les languettes 19L sont enfoncées dans le corps au niveau des bords de celui-ci et des portions 40 du corps sont présentes entre les languettes affleurant la face principale 20. Les plages de contact 9L s'arrêtent de préférence avant de parvenir aux bords latéraux du corps de module. Le moulage peut venir recouvrir les languettes 19L d'environ 100 µm pour un petit facteur de forme et peut atteindre quelques mm pour des facteurs de forme type 3FF ou 2FF.

Les languettes 19L comportent un jeu entre elles plus important que celui séparant les plages de contacts 9L auxquelles elles sont attachées de manière à éviter un éventuel court-circuit entre elles lors de leur repli au cours notamment de l'insertion dans un connecteur.

Bien entendu, il est possible de remplacer l'opération de gravure par le recours à une grille métallique prédécoupée présentant déjà les plages de contact et languettes. De préférence, la grille est un ruban métallique continu. Cette grille peut être laminée avec un substrat isolant comme précédemment.

L'invention prévoit des étapes spécifiques de gravure pour créer un module notamment de type M2M avec des languettes latérales de contact, de préférence, en supplément des plages de contacts classiques débouchant ou affleurant en surface. Les plages de contact ISO 7816 peuvent ne pas être présentes en surface du corps.

Cette invention permet d'utiliser certains connecteurs latéraux de module qui sont beaucoup plus minces que ceux classiquement utilisés, de sorte que les contacts physiques sont effectués de préférence sur le côté et non plus sur le fond du connecteur et donc toute l'épaisseur de l'embase du connecteur est gagnée sous le connecteur de l'invention; Le module peut être disposé directement contre le PCB.

Grâce à l'invention, il n'est pas nécessaire d'avoir un couvercle pour maintenir le module au contact des lames; La connexion s'effectuant sur le côté, le module est pris latéralement en sandwich entre les éléments de connexion du connecteur. Les forces de pression élastiques des éléments de connexion symétriquement opposées s'équilibrent entre elles.

Les languettes latérales sont pliées lorsque le module est inséré dans le connecteur en créant les contacts latéraux du module. Le métal cuivre est facilement pliable parce que c'est un matériau ductile.

Cette solution permet d'utiliser des connecteurs avec une très faible épaisseur (sensiblement le même que celle du module) dans la mesure où il n'est pas nécessaire de mettre un couvercle pour maintenir le module en appui sur des contacts inférieurs au fond du connecteur.

Les dimensions de la cavité du support sont ajustées avec une tolérance faible ou élevée en relation avec les dimensions du module selon qu'il soit ou non amovible. Par exemple, s'il n'est pas souhaité amovible, alors les languettes seront vraiment écrasées par les plots latéraux du connecteur et il se formera une connexion intime avec déformation des languettes. Cela pourrait améliorer le maintient du module M dans le connecteur. Dans le cas contraire, le montage peut être moins ajusté.

L'invention peut répondre au besoin de disposer d'une connexion très fiable dans un environnement sévère (avec fortes vibrations par exemple) du type moteur automobile ou comme le classique VQFN utilisant un module soudé sur PCB et qui requiert de mettre en oeuvre une température élevée. L'amovibilité ou non du module dépend également de la force élastique des plots ou éléments de connexion des connecteurs.

Dans une variante, le module peut comporter uniquement les languettes latérales et sans plages de contact apparentes et débouchant sur la face principale. Par exemple, les plages de contacts (ou pistes de liaison P) peuvent être connectées par un composant disposé du même côté que les languettes ou plages conductrices. Le substrat isolant peut être disposé en étant exposé vers l'extérieur du module M et constituer la face principale externe 20. Le surmoulage peut être effectué non pas côté du substrat mais du côté languettes, le composant étant reporté du même côté que les languettes et le surmoulage étant effectué sur la même face que celle portant les languettes. Cette variante ayant pour avantage de supprimer l'opération de perforation 32 et donc de diminuer les couts de fabrication du dit module.

## Revendications

1. Module électronique comportant un corps isolant et un jeu de contacts électriques (9L) débouchant sur une face du corps, ladite face étant délimitée par des bords latéraux, **caractérisé en ce qu'**il comprend des languettes conductrices (19L) qui s'étendent au delà des bords latéraux (22, 23) du corps à partir desdits contacts électriques (9L).

2. Module selon la revendication précédente, **caractérisé en ce que** les languettes (19L) sont destinées chacune à être repliées sensiblement à angle droit vers une face de bord latéral (22, 23) notamment au cours ou avant l'insertion dans un connecteur associé.

3. Module selon l'une quelconque des revendications précédentes, **caractérisé en ce que** les languettes (19L) sont espacées l'une de l'autre d'une distance supérieure à celle séparant les plages de contact (9L) auxquelles elles sont attachées.

4. Module selon l'une quelconque des revendications précédentes, **caractérisé en ce qu'**il constitue un module d'identification d'abonné, un module M2M.

5. Dispositif électronique comportant un connecteur (C) recevant ou destiné à recevoir le module (M) selon l'une quelconque des revendications précédentes.

6. Dispositif électronique selon la revendication précédente, **caractérisé en ce que** ledit connecteur (C) comporte :
- un cadre isolant (29) avec deux faces principales et des parois latérales internes définissant entre-elles une position fonctionnelle ou espace de réception (R) du module dans le connecteur,
- un accès à ladite position fonctionnelle disposé sur une face principale du cadre,
**caractérisé en ce que** le connecteur comporte des contacts latéraux (25) disposés sur les parois latérales internes du cadre, lesdits contacts latéraux étant destinés à connecter les languettes dudit module lorsqu'elles sont en position repliées.

7. Procédé de fabrication d'un module électronique comportant un corps isolant et des contacts électriques (9L) débouchant sur une face du corps, ladite face étant délimitée par des bords latéraux (22, 23), **caractérisé en ce qu'**il comprend l'étape suivante:
- de réalisation de languettes conductrices (19L) s'étendant au delà des bords latéraux (22, 23) du corps (18) à partir desdits contacts électriques (9L).

8. Procédé selon la revendication précédente, **caractérisée en ce qu'**il comprend les étapes suivantes :
- formation de contacts plan (9L) et languettes (19L) par gravure ou par découpe d'une grille métallique (41),
- surmoulage ou encartage dans un corps de carte d'au moins une puce électronique connectée aux contacts et disposé d'un côté des contacts;
- découpe du module, les languettes s'étendant vers l'extérieur au delà d'une face principale (20) du corps du module.

9. Procédé selon la revendication précédente, **caractérisée en ce que** les languettes (19L) sont rabattues vers les faces latérales (22, 23) du modules au cours de la découpe ou ultérieurement.
